Europäisches Patentamt

European Patent Office

Office européen des brevets

(11) Publication number: **0 148 608**
**B1**

(12) **EUROPEAN PATENT SPECIFICATION**

(45) Date of publication of patent specification: **13.04.88**

(51) Int. Cl.⁴: **H 01 B 1/08**

(21) Application number: **84308698.4**

(22) Date of filing: **13.12.84**

(54) **Film-forming composition comprising indium and tin compounds.**

(30) Priority: **22.12.83 JP 242534/83**
**09.11.84 JP 236962/84**

(43) Date of publication of application:
**17.07.85 Bulletin 85/29**

(45) Publication of the grant of the patent:
**13.04.88 Bulletin 88/15**

(84) Designated Contracting States:
**CH DE FR GB LI NL**

(56) References cited:
**EP-A-0 090 215**

(73) Proprietor: **SUMITOMO CHEMICAL COMPANY,**
**LIMITED**
**15 Kitahama 5-chome Higashi-ku**
**Osaka-shi Osaka 541 (JP)**

(72) Inventor: **Hashimoto, Tadanori**
**12-2, Tenno-cho**
**Takatsuki-shi Osaka (JP)**
Inventor: **Yoshitake, Hiroshi**
**2-1-316, Kuwata-cho**
**Ibaraki-shi Osaka (JP)**
Inventor: **Hata, Shigenao**
**2-29-7, Oike**
**Ibaraki-shi Osaka (JP)**
Inventor: **Nakazono, Akiko**
**1-24-506, Shinkouriyama**
**Ibaraki-shi Osaka (JP)**

(74) Representative: **Diamond, Bryan Clive et al**
**Gee & Co. Chancery House Chancery Lane**
**London WC2A 1QU (GB)**

Courier Press, Leamington Spa, England.

# 0 148 608

**Description**

The present invention relates to a a composition which is capable of forming a transparent electrically conductive metal oxide film on a substrate plate and a method for forming such transparent conductive film.

Electrode materials which are transparent to light have been widely used for electrodes in display devices, such as liquid crystal display devices, electroluminescense, etc., and photosensitive devices, such as photo-cells, image pick-up tubes, etc., as well as anti-clouding or anti-freezing electrodes for window glass of automobiles, aeroplanes, buildings, and the like.

As such transparent electrode materials, a tin oxide-antimony oxide type, an indium oxide-tin oxide type and the like are well known. These metal oxides can form a film on a glass or ceramic plate to provide a transparent conductive film.

The well-known methods for forming a transparent conductive film includes (1) a vacuum evaporation method, (2) a sputtering method, (3) a chemical vapor deposition method, and (4) a coating method.

However, each of the above-described methods (1), (2) and (3) has problems in that: equipments used therefor are so complicated that these methods are inferior in processability; and in usual cases, etching should be carried out after film formation in order to form patterns.

The above-described method (4) offers a possibility of solving the aforesaid problems associated with the methods (1) to (3), but there still is a problem that it is difficult to obtain a transparent conductive thin film which can withstand practical use.

For example, a method of using an organic solution of an inorganic salt, e.g., $InCl_3$, $In(NO_3)_3$, $SnCl_4$, etc., involves disadvantages such as causing milky turbidity of the resulting conductive film or insufficient mechanical strength to easily get scratches.

A method of using an indium salt of an organic acid having a strong ionic bond, such as indium octylate, involves a disadvantage such as causing gelation of the coating composition because of tendency to readily hydrolyze and easily occur chemical change.

A method of using an organic complex of indium or tin involves a disadvantage such as hindrance in homogenization of the baked film upon thermal decomposition of the coated film formed on the substrate plate, thus causing nonuniformity or insufficient sheet resistivity.

Moreover, in any of the above described cases, when a transparent conductive film is formed on a soda glass substrate plate, silica coating must be performed on the soda glass substrate plate to prevent elution of sodium ions from the soda glass plate.

An object of the present invention is to provide a novel composition which is capable of forming a transparent conductive film.

Another object of the present invention is to provide a composition which needs no silica coating procedure to prevent elution of sodium ion from the soda glass.

A further object of the present invention is to provide a method for producing a transparent conductive film having a two-layered structure and a strong adhesion strength to a substrate plate.

The composition of the present invention is a mixture of an organic solution of an indium salt of an inorganic acid and a tin salt of an inorganic acid with a non-aqueous silica sol.

The method for forming a transparent conductive film of the present invention comprises:

(1) coating the composition on a substrate plate,

(2) drying the thus coated substrate plate, and then

(3) heat baking the dried substrate plate.

An important characteristic of the present invention resides in that the composition contains a non-aqueous silica sol. The non-aqueous silica sol contains hyperfine particles each having on the surface thereof a silanol group capable of imparting a thixotropic effect. The non-aqueous silica sol provides an improved wettability to the composition, whereby the transparent conductive film obtained can show excellent transmittance, conductivity and adhesion property.

The coated film formed by coating the composition, drying and then heat baking according to the method of the present invention has a completely two-layered structure. That is, the upper layer consists of indium tin oxide and the lower layer consists of silica. This structure was identified by the following surface analyses.

The presence of the upper layer (referred to as "ITO layer" hereinafter) was confirmed by electron spectroscopy for chemical analysis and X-ray diffraction analysis of the surface of the coated film as well as chemical analysis of a solution obtained by hydrochloric acid-etching of the surface. Further, the presence of the lower layer (referred to as "$SiO_2$ layer" hereinafter) was confirmed by the same spectrographic and X-ray analyses of the etched surface as well as chemical analysis of a solution obtained by hydrofluoric acid-etching of the etched surface.

Therefore, according to the method of the present invention, it is possible to omit a silica coating procedure so far necessary to thereby minimize the total cost.

The composition of the present invention will be described below in more detail.

The indium salt of an inorganic acid that can be used in the present invention is generally an indium salt of a mineral acid such as indium chloride or indium nitrate. The content of the indium salt is generally

2

about 0.5% to about 30% by weight, preferably about 1% to about 20% by weight (calculated as indium oxide), in order to obtain a transparent conductive film showing low resistivity.

The tin salt of an inorganic acid that can be used in the present invention is generally a tin salt of a mineral acid such as stannic chloride. The content of the tin salt is generally about 0.5% to about 30% by weight, preferably about 1% to about 20% by weight, in terms of the proportion of tin to indium, in order to lower the resistivity of a transparent conductive film.

The indium salt and tin salt may be each a hydrate thereof.

The non-aqueous silica sol that can be used in the present invention is not particularly limited, but a silica sol obtained by hydrolyzing orthoethyl silicate in the presence of a catalyst and a silica sol obtained by reacting tetrachlorosilane with acetic anhydride, followed by hydrolyzing in the presence of a catalyst can be preferably used. More preferably, an organic solution of silicic acid prepared by liquid-phase neutralization of an aqueous solution of sodium silicate with a mineral acid such as sulfuric acid, followed by subjecting the neutralized solution to salting-out with a salting-out agent and extraction with an extractant, can be used. Examples of the extractant include organic solvents such as tetrahydrofuran, isopropyl alcohol and t-butanol. Examples of the salting-out agent include sodium chloride and ammonium chloride. The thus prepared non-aqueous silica sol is inexpensive and can be prepared easily.

The non-aqueous silica sol as prepared above is a transparent solution which shows excellent stability with a lapse of time and contains silica particles having a particle size of about 0.02 μm to about 0.1 μm. The concentration of the silica in the non-aqueous silica sol is not particular limited, but it is usually in the range of from about 1% to about 20% by weight as $SiO_2$.

The content of the non-aqueous silica sol added in the composition is about 1% to about 200% by weight, preferably about 10% to about 100% by weight, in terms of the proportion of $SiO_2$ to indium oxide.

The organic solvent used is selected taking into account solubilities of the indium salt and the tin salt, compatibility with the non-aqueous silica sol, and solubility of a cellulose compound described below. The organic solvent is not particularly limited but includes acetone, tetrahydrofuran, methanol, ethanol, isopropyl alcohol, t-butanol, ethylene glycol, diethylene glycol, ethyl cellosolve and ethyl carbitol. These organic solvents can be used singly or in combination.

As a thickener, cellulose compounds may be added to the composition of the present invention to thereby increase its thixotropy and obtain a transparent conductive film having superior properties. The particular cellulose compound added to the composition of the present invention is not particularly limited, but it is selected taking into account solubility in the organic solvent, thickening property, dispersability, thermoplastic property, pyrolysis property and the like. Examples of the cellulose compound include ethyl cellulose, nitrocellulose, cellulose acetate, hydroxypropyl cellulose and ethyl hydroxyethyl cellulose. Among them, nitrocellulose, cellulose acetate, hydroxypropyl cellulose and ethyl hydroxyethyl cellulose can be preferably used because they prevent a hygroscopic phenomenon of the coating composition under high temperature and humidity atmosphere. Therefore, addition of the cellulose compound is effective for preventing the hindrance in homogenization of the coating composition and milky turbidity of the conductive film.

The content of the cellulose compound in the composition of the present invention is not particularly limited but generally ranges from about 0.1% to about 5% by weight for the dipping and spinning methods and from about 10% to about 50% by weight for the screen and offset printing methods, respectively.

The composition of the present invention thus prepared shows an excellent stability with a lapse of time, and even when allowed to stand for 3 months, it undergoes no gelation. Further, the film obtained by coating the composition on a substrate plate, drying, and then heat baking the substrate plate suffers no impariment of these properties.

The method for forming a transparent conductive film of the present invention will be described below.

Coating of the composition of the present invention can be carried out by commonly employed coating techniques, such as dipping, spinning, screen printing, offset printing, etc.

The thus coated composition is generally subjected to a drying treatment at about 40°C to about 250°C and then to a heat baking treatment at about 400°C to about 900°C, to thereby form a transparent conductive film. The heat baking should be performed in an oxygen-containing gas atmosphere in order to provide a sufficient amount of oxygen to the composition.

The present invention will now be illustrated in greater detail with reference to the following examples.

Example 1

Prescribed amounts of indium chloride and stannic chloride were dissolved in tetrahydrofuran, and the solution was mixed with a non-aqueous silica sol having a concentration of 5% by weight (as $SiO_2$). The non-aqueous silica sol mixed was prepared by neutralizing an aqueous solution containing sodium silicate with sulfuric acid and subjecting the neutralized solution to salting-out with ammonium chloride and extraction with tetrahydrofuran. Then, a prescribed amount of a cellulose compound shown in Table 1 was added to the solution and stirred well. There were thus prepared compositions shown in Table 1.

3

TABLE 1

Composition

| Composition No. | $InCl_3$ (wt.%) | Converted to basis of $In_2O_3$ (wt.%) | $SnCl_4$ (wt.%) | Converted to basis of Sn/In (wt.%) | $SiO_2$ (wt.%) | Converted to basis of $SiO_2/In_2O_3$ (wt.%) | Cellulose compound | |
|---|---|---|---|---|---|---|---|---|
| | | | | | | | Name | Amount (wt.%) |
| A | 6.4 | 4.0 | 0.7 | 9.6 | 1.6 | 40 | hydroxypropyl cellulose | 1.0 |
| B | 6.4 | 4.0 | 0.7 | 9.6 | 1.6 | 40 | nitrocellulose | 1.0 |
| C | 3.2 | 2.0 | 0.4 | 11.0 | 0.8 | 40 | cellulose acetate | 4.0 |
| D | 8.0 | 5.0 | 0.9 | 9.9 | 2.0 | 40 | ethyl hydroxyethyl cellulose | 1.0 |
| E | 6.4 | 4.0 | 0.7 | 9.6 | 1.6 | 40 | ethyl cellulose | 1.0 |
| F | 10.0 | 6.3 | 1.1 | 9.7 | 2.5 | 40 | — | — |

Each of the compositions shown in Table 1 was coated on a well-cleaned soda glass substrate by the dipping method under the conditions shown in Table 2. The coated substrate plate was dried in air at 80°C for 15 minutes and then baked at 500°C for 1 hour in air, to thereby obtain a transparent conductive film. The properties of the resulting transparent conductive film are shown in Table 2.

Each of the thus obtained transparent conductive films had a two-layered structure and showed low resistivity and excellent transmittance. The adhesion strength of the film to the substrate plate was sufficient to stand the peeling test with an adhesive tape. Thus it is evident that the properties of the film were improved by addition of the cellulose compound to the composition.

TABLE 2

| Composition No. | Draw speed in dipping (cm/min) | Coating atmosphere | | Properties of baked film | | | |
|---|---|---|---|---|---|---|---|
| | | Temperature (°C) | Humidity (%) | Thickness of ITO layer (Å) | Thickness of $SiO_2$ layer (Å) | Sheet resistivity ($\Omega/\square$) | Transmittance (% at 550 nm) |
| A | 45 | 15 | 50 | 1200 | 1600 | 400 | 85 |
| | 50 | 30 | 74 | 1200 | 1600 | 400 | 85 |
| B | 45 | 15 | 50 | 1100 | 1450 | 500 | 86 |
| | 50 | 30 | 74 | 1100 | 1450 | 500 | 86 |
| C | 25 | 15 | 50 | 1300 | 1700 | 300 | 82 |
| | 30 | 30 | 74 | 1300 | 1700 | 300 | 82 |
| D | 50 | 15 | 50 | 1100 | 1450 | 600 | 86 |
| | 60 | 30 | 74 | 1100 | 1450 | 600 | 86 |
| E | 45 | 15 | 50 | 1200 | 1600 | 400 | 85 |
| | 50 | 30 | 74 | 1200 | 1600 | 600 | 74 |
| F | 50 | 15 | 50 | 1200 | 1600 | 800 | 84 |
| | 60 | 30 | 74 | 1200 | 1600 | 1500 | 70 |

Example 2

Prescribed amounts of indium chloride and stannic chloride were dissolved in ethanol, and the solution was mixed with a non-aqueous silica sol having a concentration of 8% by weight (as $SiO_2$). The non-aqueous silica sol mixed was prepared by neutralizing an aqueous solution containing sodium silicate with sulfuric acid and subjecting the neutralized solution to salting-out with ammonium chloride and extraction with isopropyl alcohol. Then, a prescribed amount of ethyl cellulose was added to the solution and stirred well. There were thus prepared paste-like compositions shown in Table 3.

Each of the resulting compositions was screen printed on a well-cleaned quartz substrate plate at temperature of 15°C and at a humidity of 50%. The coated substrate plate was dried in air at 100°C for 15 minutes and then baked at 500°C for 1 hour in air, to thereby obtain a transparent conductive film. The properties of the resulting transparent conductive film are shown in Table 3.

0 148 608

TABLE 3

| Composition | | | | | | | | | Properties of baked film | |
|---|---|---|---|---|---|---|---|---|---|---|
| $InCl_3$ (wt.%) | Converted to basis of $In_2O_3$ (wt.%) | $SnCl_4$ (wt.%) | Converted to basis of Sn/In (wt.%) | $SiO_2$ (wt.%) | Converted to basis of $SiO_2/In_2O_3$ (wt.%) | Ethyl cellulose (wt.%) | Isopropyl alcohol (wt.%) | Ethanol (wt.%) | Thickness of ITO layer (Å) | Sheet resistivity ($\Omega/\square$) |
| 8.0 | 5.0 | 0.9 | 9.9 | 2.0 | 40 | 10.0 | 23.0 | 56.1 | 1000 | 800 |
| 8.0 | 5.0 | 0.9 | 9.9 | 2.0 | 40 | 18.0 | 23.0 | 48.1 | 2000 | 400 |

**0 148 608**

As is apparent from the above-described examples, the composition of the present invention is very useful as a composition for forming a transparent conductive film which shows low sheet resistivity and excellent adhesion strength to a substrate plate.

**Claims**

1. A composition for forming a transparent conductive film comprising a mixture of (a) an organic solvent solution of an indium salt of an inorganic acid and a tin salt of an inorganic acid with (b) a non-aqueous silica sol.

2. A composition as claimed in Claim 1, wherein said composition contains 0.5% to 30% by weight of said indium salt calculated as indium oxide, 0.5% to 30% by weight of said tin salt in terms of the proportion of tin to indium, and 1% to 200% by weight of said non-aqueous silica sol in terms of the proportion of silica to indium oxide.

3. A composition as claimed in Claim 1 or 2, wherein said non-aqueous silica sol is one prepared by liquid-phase neutralization of an aqueous solution containing sodium silicate with a mineral acid and subjecting the neutralized solution to salting-out with a salting-out agent and extraction with an organic solvent.

4. A composition as claimed in Claim 1, 2 or 3, wherein a cellulose compound is added to said composition as a thickener in an amount of 0.1% to 50% by weight in said composition.

5. A method for producing a transparent conductive film which comprises:
(1) coating a composition as claimed in any preceding claim on the surface of a plate,
(2) drying the coated plate, and
(3) heat baking the coated substrate plate.

6. A transparent conductive film, produced by a process as claimed in Claim 5.

**Patentansprüche**

1. Zusammensetzung zur Bildung eines durchsichtigen leitenden Films, enthaltend ein Gemisch von
a) einer Lösung eines Indiumsalzes einer anorganischen Säure und eines Zinnsalzes einer anorganischen Säure in einem organischen Lösungsmittel und
b) einem nicht-wäßrigen Siliciumdioxid-Sol.

2. Zusammensetzung nach Anspruch 1, enthaltend 0,5 bis 30 Gew.-% des Indiumsalzes, berechnet als Indiumoxid, 0,5 bis 30 Gew.-% des Zinnsalzes, bezogen auf das Verhältnis von Zinn zu Indium, und 1 bis 200 Gew.-% des nicht-wäßrigen Siliciumdioxid-Sols, bezogen auf das Verhältnis von Siliciumdioxid zu Indiumoxid.

3. Zusammensetzung nach Anspruch 1 oder 2, in der das nicht-wäßrige Siliciumdioxid-Sol durch Neutralisation in der flüssigen Phase einer wäßrigen Natriumsilicatlösung mit einer anorganischen Säure, Aussalzen der neutralisierten Lösung mit einem Aussalzmittel und Extrahieren mit einem organischen Lösungsmittel erhältlich ist.

4. Zusammensetzung nach einem der Ansprüche 1—3, mit dem zusätzlichen Gehalt einer Celluloseverbindung als Verdickungsmittel in einer Menge von 0,1 bis 50 Gew.-% der Zusammensetzung.

5. Verfahren zur Herstellung eines durchsichtigen leitenden Films durch
1) Beschichten einer Plattenoberfläche mit der Zusammensetzung nach einem der vorstehenden Ansprüche,
2) Trocknen der beschichteten Platte und
3) Härten durch Erhitzen der beschichteten Substratplatte.

6. Durchsichtiger leitender Film, erhältlich in dem Verfahren nach Anspruch 5.

**Revendications**

1. Composition pour la formation d'un film conducteur transparent comprenant un mélange (a) d'une solution dans un solvant organique d'un sel d'indium d'un acide inorganique et d'un sel d'étain d'un acide inorganique, avec (b) un sol de silice non-aqueux.

2. Composition selon la revendication 1, dans laquelle ladite composition contient 0,5 à 30% en poids dudit sel d'indium calculé comme oxyde d'indium, 0,5 à 30% en poids dudit sel d'étain en termes de la proportion d'étain par rapport à l'indium, et 1 à 200% en poids dudit sol de silice non-aqueous en termes de la proportion de silice par rapport à l'oxyde d'indium.

3. Composition selon la revendication 1 ou la revendication 2, dans laquelle ledit sol de silice non-aqueux est un sol préparé par neutralisation de la phase liquide d'une solution aqueuse contenant du silicate de sodium avec un acide minéral et traitement de relargage de la solution neutralisée avec un agent de relargage, puis extraction avec un solvant organique.

4. Composition selon la revendication 1, 2 ou 3, dans laquelle un composé de cellulose est ajouté à ladite composition comme épaississant en une quantité de 0,1 à 50% en poids dans ladite composition.

9

5. Méthode pour la formation d'un film conducteur transparent qui comprend:
(1) le dépôt d'une composition selon l'une des revendications précédentes sur la surface d'une plaque,
(2) le séchage de la plaque revêtue, et
(3) le durcissement thermique de la plaque de substrat revêtue.
6. Film conducteur transparent obtenu par le procédé selon la revendication 5.